# EUROPEAN PATENT APPLICATION

(11) **EP 2 978 038 A1**
(43) Date of publication of application: **27.01.2016**
(21) Application number: 14425101.4
(22) Date of filing: 24.07.2014
(51) Int. Cl.: H01L 51/52

(54) **Organic electroluminescent transistor**

(71) Applicant: E.T.C. S.r.l., 40129 Bologna BO (IT); Polyera Corporation, Skokie, IL 60077 (US)
(72) Inventor: Muccini, Michele, 40121 Bologna BO (IT); Turatti, Guido, 44026 Bosco Mesola FE (IT); Biondo, Viviana, 33028 Illegio Tolmezzo UD (IT); Chen, Xiaoyan, Glenview, IL 60025 (US); Facchetti, Antonio, Chicago, IL 60640 (US)
(74) Representative: Barbaro, Gaetano

(57) **Abstract**

This disclosure relates to an organic electroluminescent transistor with improved light emission characteristics. More specifically, the present organic electroluminescent transistor has an emissive ambipolar channel that includes at least one layer of an n-type semiconductor material, at least one layer of a p-type semiconductor material and at least one layer of an emissive material arranged between the layers of p-type and n-type semiconductor materials, the emissive material comprising a arylamine matrix compound selected among compounds represented by either formula (H-1) or (H-2) 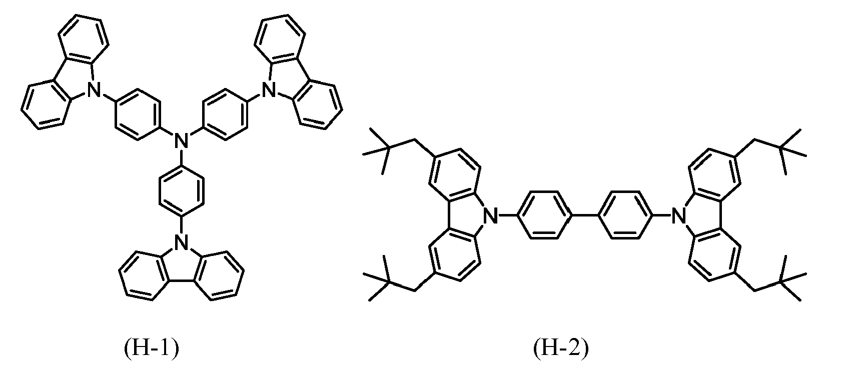 and an emitter being selected among compounds represented by formula (G-1), (G-2), or (G-3)

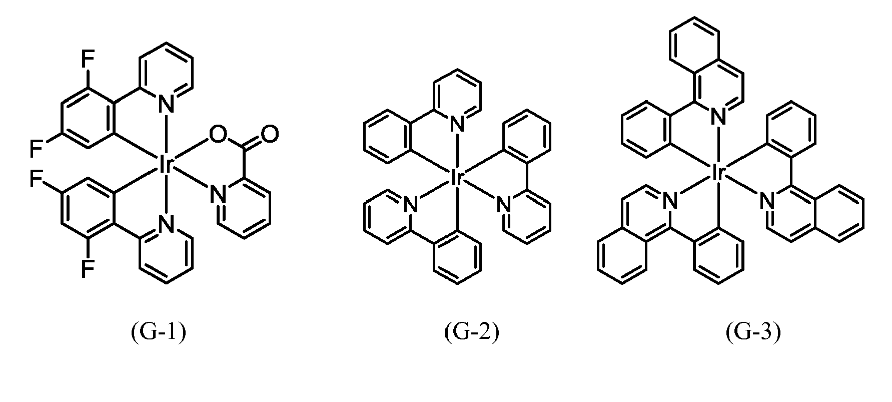

## Description

### BACKGROUND

This invention relates to an organic electroluminescent transistor with improved light emission characteristics.

The present description and the enclosed claims refer to the light emission characteristics, and in particular to the simultaneous achievement of maximum brightness and efficiency, of an electroluminescent transistor based on a multilayer structure.

Organic electroluminescent field effect transistors, also known as OLETs (Organic Light Emitting Transistors) are a relatively recent type of devices, that have characteristics and potentialities that make them particularly interesting. In particular, compared with OLEDs (Organic Light Emitting Diodes), ambipolar OLETs have enhanced efficiency and luminosity, and also the possibility of using low-cost production processes, once they have been optimized.

Further details about the structure of an ambipolar OLET device may be found in European Patent No. EP 1609195. More specifically, EP 1609195 upon the teaching of which the preamble of the enclosed claim 1 is drafted, discloses a three-layer organic light emitting transistor having an emissive ambipolar channel comprising at least one layer of an n-type semiconductor material, at least one layer of a p-type semiconductor material and at least one layer of an emissive material arranged between said layers of p-type and n-type semiconductor materials. Further details about the potentialities and the functional characteristics of these devices may be found in the article "Organic light-emitting transistors with an efficiency that outperforms the equivalent light-emitting diodes" published in 2010 by Nature Materials, Volume 9, pages 496-503. The three-layer organic light emitting transistor disclosed in the article has a layer of an n-type semiconductor material composed of 5,5'-bis((5-perfluorohexyl)thiophen-2-yl)-2,2'-bithiophene (DFH4T), a layer of a p-type semiconductor material composed of 5,5'-bis(3-hexyl-2-thienyl)-2,2'-bithiophene (DH4T), and a layer of an emissive material composed of tris(8-hydroxyquinolinato)aluminium:4-(dicyanomethylene)-2-methyl-6-(p-dimethylaminostyryl)-4H-pyran (Alq₃:DCM).

As alternative, the International Patent Application No. WO2013/128344 disclosed other three-layer OLET structures, each one comprising a layer of emissive material that have been selected among host-guest systems wherein the host matrix is tris(8-hydroxyquinolinato)aluminium (Alq₃) or 4,4',4"-tris(carbazole-9-yl)triphenylamine (TCTA), and the guest emitter is 2,3,7,8,12,13,17,18-octaethylporphyrin-22,24-diide; platinum(2+) (PtOEP) or 4-(dicyanomethylene)-2-methyl-6-(4-dimethylaminostyryl)-4H-pyran (DCM).

So far, all studies and characterizations have shown that ambipolar OLET devices have an enhanced luminosity, though obtained at bias conditions where the efficiency of charge current conversion into light emission is very low (in the order of 1 x 10⁻¹ %). Conversely, the device efficiency can be usually maximized by modifying its bias conditions but with detrimental effects on the luminosity. These emission characteristics limit the possible application fields when high brightness and high efficiency are simultaneously needed, such as for example in the field of the technology of light emitting displays, of the so-called biomedical applications Point of Care, of sources at high integrated luminosity on photonic chips. Further improvement in electroluminescence intensity (from the order of nanoWatt (nW) to microWatt (µW) with constant device geometry) is also desirable.

### SUMMARY

An objective of this disclosure is to provide an organic electroluminescent transistor for overcoming the above mentioned drawbacks of prior art, with particular reference to maximize simultaneously the light emission efficiency and brightness of the OLET and of the device containing it.

In one embodiment, an organic electroluminescent transistor according to this disclosure comprises at least one dielectric layer, at least one control electrode, an assembly comprising an emissive ambipolar channel, at least one source electrode and at least one drain electrode, wherein:
the dielectric layer is arranged between the control electrode and the assembly;
the ambipolar channel comprises at least one layer of an n-type semiconductor material, at least one layer of a p-type semiconductor material and at least one layer of an emissive material arranged between the layers of p-type and n-type semiconductor materials;
the p-type semiconductor material is suitable to transport holes across the ambipolar channel of the transistor;
the n-type semiconductor layer is suitable to transport electrons across the ambipolar channel of the transistor; and
the emissive layer comprises a blend material comprising a carbazole derivative as a host matrix compound and an iridium complex as a guest emitter.

In preferred embodiments, the emissive layer comprises a blend material selected among 4,4',4"-tris(carbazole-9-yl)triphenylaminearis(1-phenylisoquinoline)iridium(III) (TCTA:Ir(piq)₃), 4,4'-bis(3,6-dineopentyl-9H-carbazole-9-yl)-1,'-biphenyl:tris(1-phenylisoquinoline)iridium(III) (NP4-CBP:Ir(piq)₃), 4,4'-bis(3,6-dineopentyl-9H-carbazole-9-yl)-1,'-biphenyl:tris(2-phenylpyridine)iridium(III) (NP4-CBP:Ir(ppy)), and 4,4'-bis(3,6-dineopentyl-9H-carbazole-9-yl)-1,'-biphenyl:bis(4,6-difluorophenyl-pyridine)(picolinate)iridium(III) (NP4-CBP:FIrpic).

In one embodiment, the p-type semiconductor material is selected among condensed polycyclic aromatic compounds, preferably among benzothieno-benzothiophene compounds or dinaphtho-thienothiophene compounds.

In one embodiment, the n-type semiconductor material is selected among bis(p-fluoroalkyl)phenyl-substituted oligomeric thiophene compounds, wherein the oligomeric thiophene compounds have 2, 3, 4, 5 or 6 thiophene moieties, optionally wherein two or more of the thiophene moieties are fused.

In various embodiments, the organic electroluminescent transistor can include one or more additional layers selected from the group consisting of a hole-injection sublayer, an electron-injection sublayer, and a passivation layer. In one embodiment, as example, the source electrode is in contact with the layer of p-type semiconductor material and the drain electrode is in contact with the layer of n-type semiconductor material. In another embodiment, an injection sublayer can be interposed between the source electrode and the layer of p-type or n-type semiconductor material and/or an injection sublayer is interposed between the drain electrode and the layer of p-type or n-type semiconductor material.

The foregoing as well as other features and advantages of the present teachings will be more clearly understood from the following figures, description, examples, and claims. The claims as filed are an integral part of this specification and are herein incorporated by reference.

### BRIEF DESCRIPTION OF THE DRAWINGS

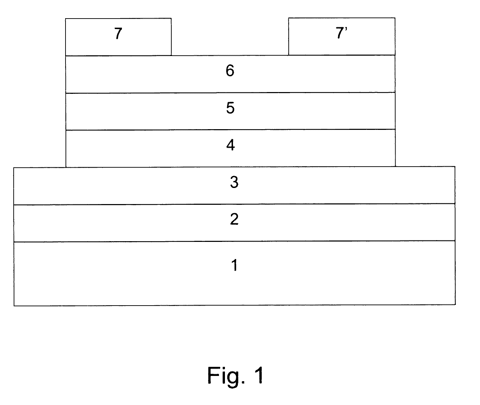

Figure 1 is a cross-sectional view of an organic light emitting transistor (OLET) according to this disclosure, which includes a substrate (1), a control electrode (2), a dielectric layer (3), an assembly comprising an emissive ambipolar channel that includes a layer of a first-type of semiconductor material (4), a layer of an emissive material (5), and a layer of a second-type of semiconductor material (6), and a electron electrode and a hole electrode (7 and 7').

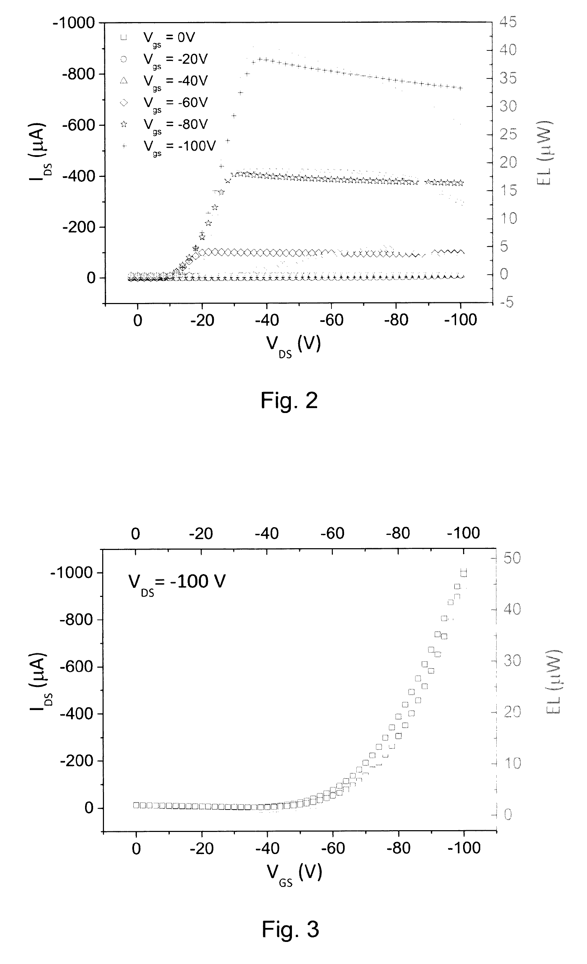

Figure 2 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a first exemplary embodiment.
Figure 3 depicts graphs of the drain-source current I_{DS} (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the first exemplary embodiment.

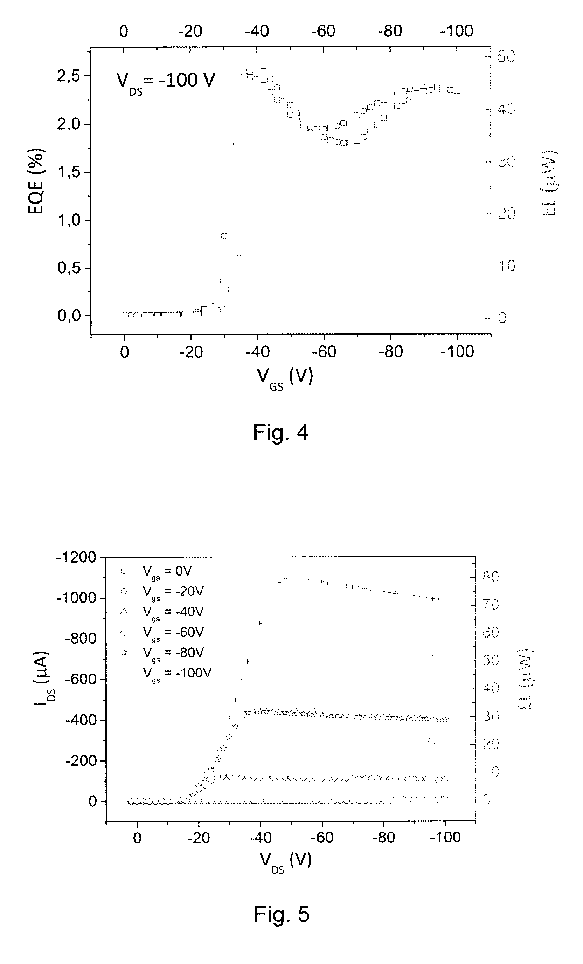

Figure 4 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the first exemplary embodiment.
Figure 5 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a second exemplary embodiment.

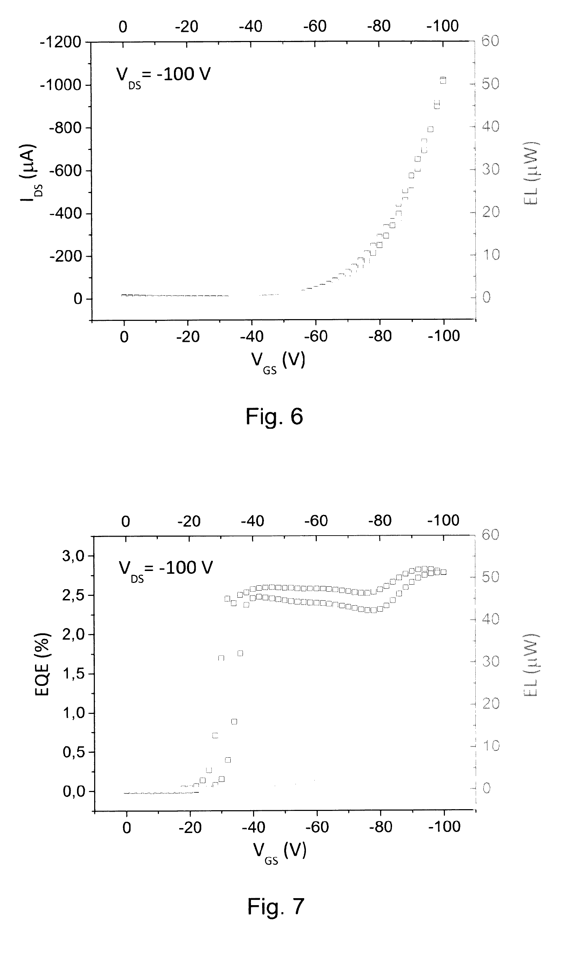

Figure 6 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the electroluminescent transistor according to the second exemplary embodiment.
Figure 7 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the second exemplary embodiment.

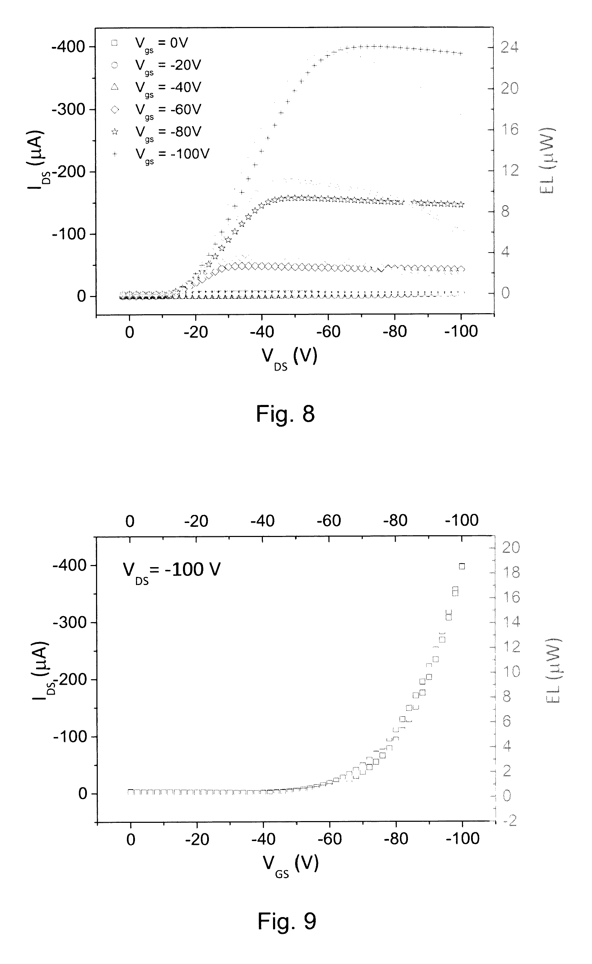

Figure 8 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a third exemplary embodiment.
Figure 9 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the electroluminescent transistor according to the third exemplary embodiment.

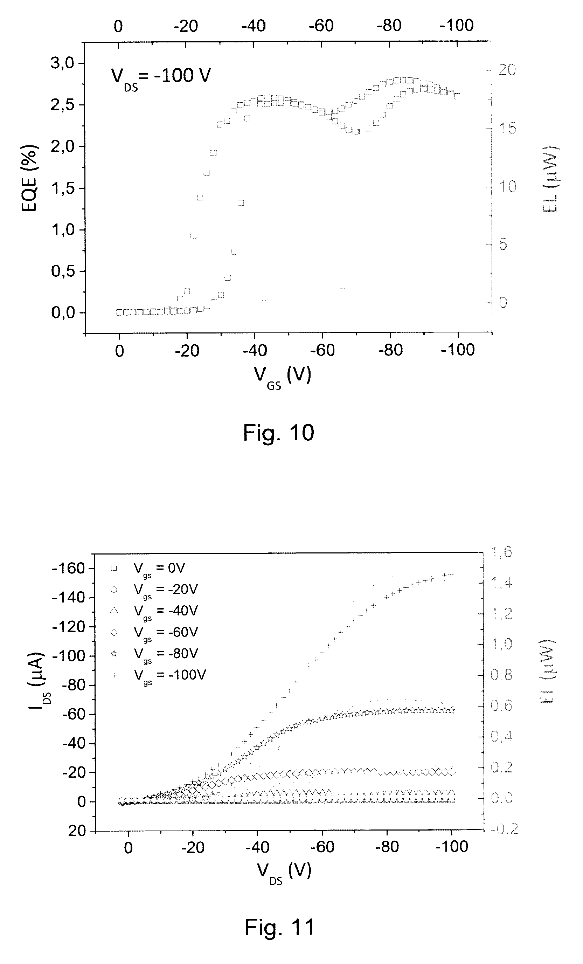

Figure 10 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the third exemplary embodiment.
Figure 11 depicts graphs of the drain-source current I_{DS} (left scale - black curves) and of the electro-luminescence optical output power EL (right scale - gray curves) as a function of the drain-source voltage V_{DS} at different values of the gate-source voltage V_{GS}, for an electroluminescent transistor according to a fourth exemplary embodiment.

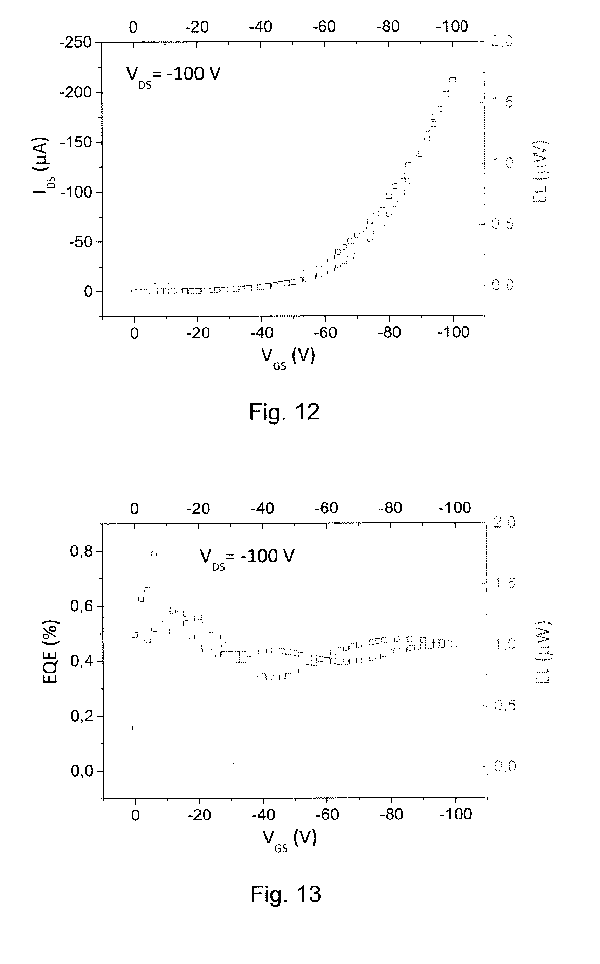

Figure 12 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the electroluminescent transistor according to the fourth exemplary embodiment.
Figure 13 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the electroluminescent transistor according to the fourth exemplary embodiment.

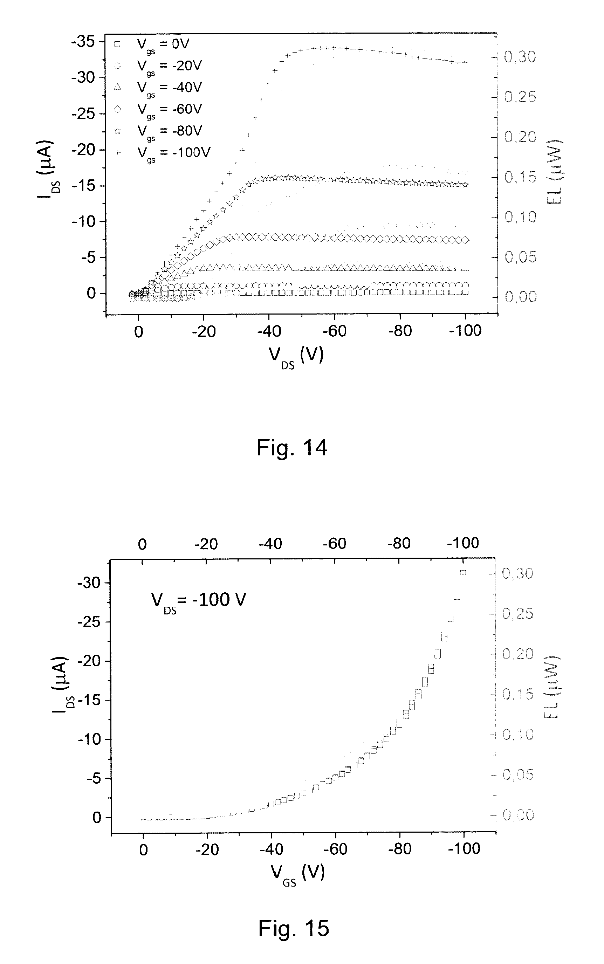

Figure 14 depicts graphs of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), for a first comparative electroluminescent transistor not according to the present invention.
Figure 15 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of -100V and the source contact was grounded (V_{DS} = -100V), for the first comparative electroluminescent transistor.

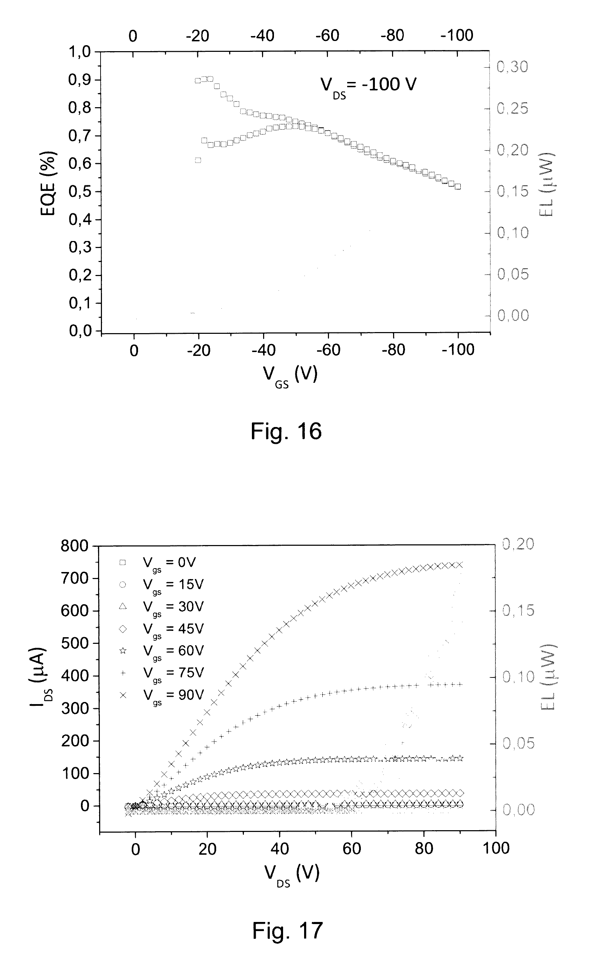

Figure 16 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V), for the first comparative electroluminescent transistor.
Figure 17 depicts graphs of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), for a second comparative electroluminescent transistor not according to the present invention.

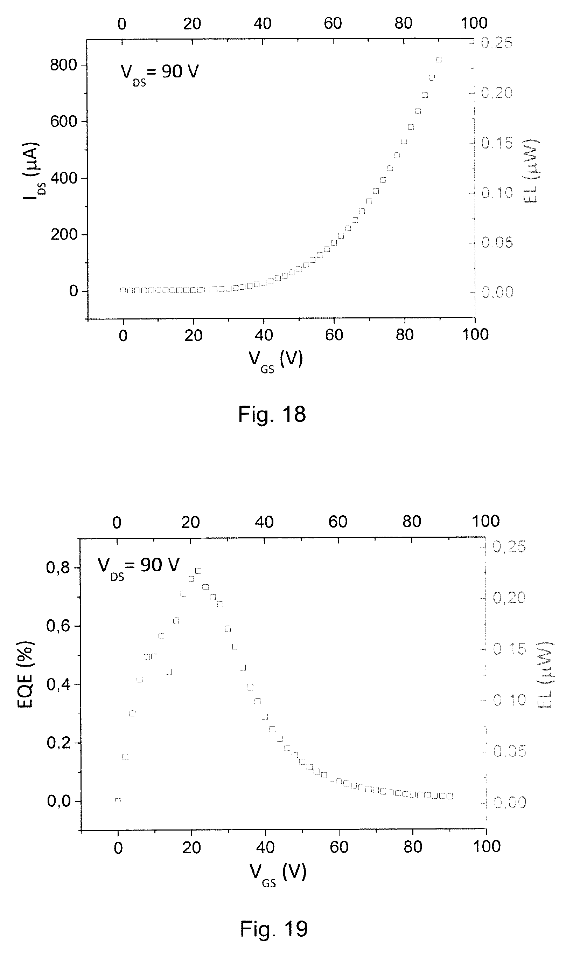

Figure 18 depicts graphs of the drain-source current I_{DS} (left scale - black curve) and of the electro-luminescence optical output power EL (right scale - gray curves) in function of the gate-source voltage V_{GS} whilst the drain contact was maintained at a constant bias voltage of 90V and the source contact was grounded (V_{DS} = 90V), for the second comparative electroluminescent transistor.
Figure 19 depicts graphs of the external quantum efficiency (left scale - black curve) and of the electro-luminescence optical output power EL (right scale - gray curves) as a function of the gate-source voltage V_{GS} whilst the drain contact was maintained at a constant bias voltage of 90V and the source contact was grounded (V_{DS} = 90V), for the second comparative electroluminescent transistor.

### DETAILED DESCRIPTION

An embodiment of an electroluminescent transistor with simultaneous maximum brightness and efficiency according to this disclosure is shown in figure 1.

In this particular embodiment, the electroluminescent transistor comprises a substrate 1 that acts as a supporting layer, over which there is an electrode 2 that acts as control or gate electrode and that may be a transparent electrode, a layer of dielectric material 3, over which there is a light emitting assembly. This assembly includes a charge carrier transport layer of a first type 4, a layer 5 of emissive material and a charge carrier transport layer of a second type 6. Source and drain electrodes 7 and 7' are realized so as to inject charge carriers into the light emitting assembly.

The charge carrier transport layer of the first type 4 for example may be a hole transport layer made of a p-type semiconductor material and the charge carrier transport layer of the second type 6 may be an electron transport layer made of a n-type semiconductor material, though the opposite is possible.

In the shown embodiment, the source and drain electrodes are directly in contact with the charge carrier transport layer of the second type 6. According to an alternative embodiment not shown in the figures, an injection sublayer is interposed between the source electrode and the layer 6 and/or between the drain electrode and the layer 6. Instead of the bottom-gate architecture depicted in Figure 1, the organic electroluminescent transistor can have a top-gate architecture. Further, the hole and electron electrodes and/or the control electrode can have alternative arrangements as described in International Publication No. WO 2014/035841. Specifically, the hole and electron electrodes can be in contact with different layers of the light-emitting assembly. For example, the hole electrode can be in contact with the layer of p-type semiconductor material, while the electron electrode can be in contact with the layer of n-type semiconductor material. Furthermore, as described in International Publication Nos. WO 2013/018002, WO 2013/017999, WO 2014/035842, and WO 2013/018000, additional control electrode(s) and/or additional layer(s) of dielectric material, emissive material, and/or charge carrier transport materials can be incorporated into the organic electroluminescent transistor. Optionally, a passivation layer can be present covering the top surface of the emissive ambipolar channel.

The inventors have found that the organic electroluminescent transistors can have enhanced light emission if the emissive layer comprises a carbazole derivative compound as a host matrix compound and an iridium-based complex as a guest emitter. In preferred embodiments, the emissive layer is a blend material comprising a host matrix compound represented by either formula (H-1) (TCTA) or formula (H-2) (NP4-CBP) and a guest emitter represented by formula (G-1) (FIrpic), (G-2) (Ir(ppy)), or (G-3) (Ir(piq)₃) as provided below. For example, the blend material can be selected among 4,4',4"-tris(carbazole-9-yl)triphenylamine:tris(1-phenylisoquinoline)iridium(III) (TCTA:Ir(piq)₃), 4,4'-bis(3,6-dineopentyl-9H-carbazole-9-yl)-1,'-biphenylaris(1-phenylisoquinoline)iridium(III) (NP4-CBP:Ir(piq)₃), 4,4'-bis(3,6-dineopentyl-9H-carbazole-9-yl)-1,'-biphenyl:tris(2-phenylpyridine)iridium(III) (NP4-CBP:Ir(ppy)), and 4,4'-bis(3,6-dineopentyl-9H-carbazole-9-yl)-1,'-biphenyl:bis(4,6-difluorophenyl-pyridine)(picolinate)iridium(III) (NP4-CBP:FIrpic).

In various embodiments, the layer of emissive material can include between 10% and 22% of its total weight of the emitter.

For example, in embodiments where the emissive material is blue-emitting, the emissive material can include a blend of the arylamine matrix compound of (H-1) and the blue emitter of formula (G-1): 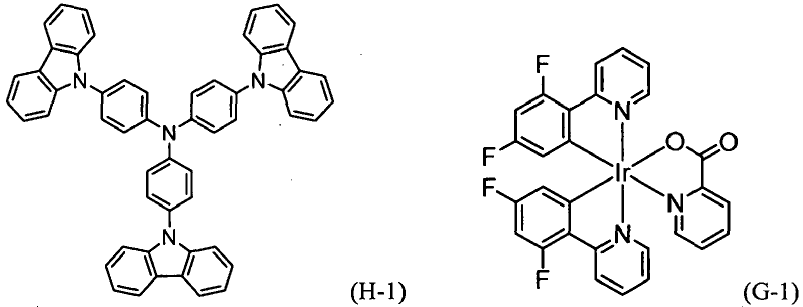 or a blend of the arylamine matrix compound of formula (H-2) and the blue emitter of formula (G-1):

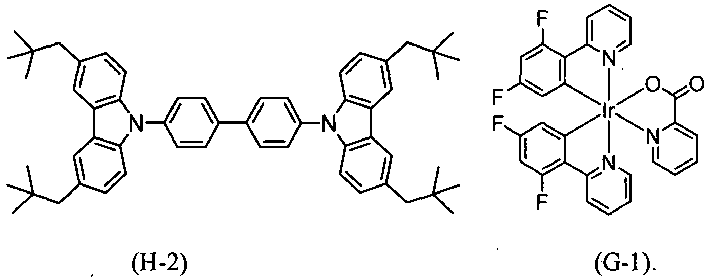

In embodiments where the emissive material is green-emitting, the emissive material can include a blend of the arylamine matrix compound of formula (H-1) and the green emitter of formula (G-2): 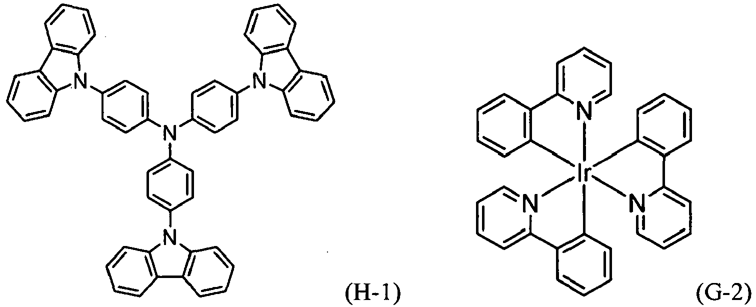 or a blend of the arylamine matrix compound of formula (H-2) and the green emitter of formula (G-2):

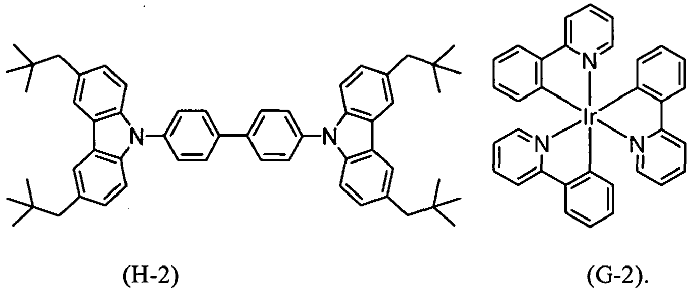

In embodiments where the emissive material is red-emitting, the emissive material can include a blend of the arylamine matrix compound of formula (H-1) and the red emitter of formula (G-3): 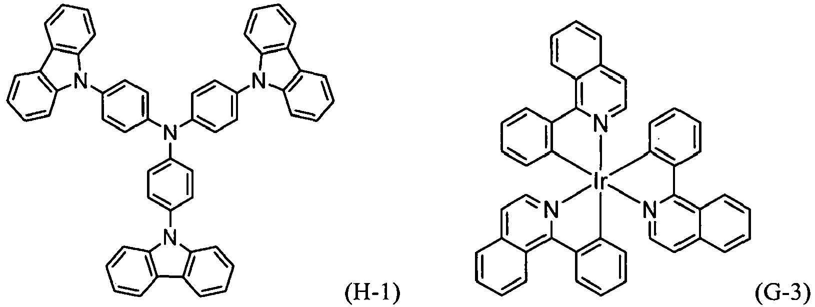 or a blend of the arylamine matrix compound of formula (H-2) and the red emitter of formula (G-3):

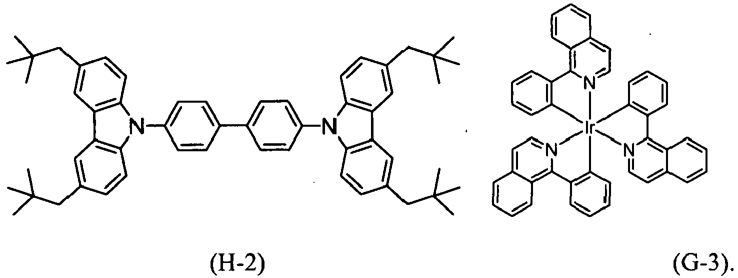

The layer of p-type semiconductor material can include a hole-transporting compound selected from the group consisting of an oligothiophene, an acene, and a fused heteroarene. In some embodiments, the p-type semiconductor material can include a hole-transporting compound selected from the group consisting of a dithiophene, a quaterthiophene, a thienothiophene, a benzothiophene, a naphthothiophene, a benzothieno[3,2-b][1]benzothiophene, and a dinaphtho[2,3-b:2',3'-f]thieno[3,2-b]thiophenes, each of which can be optionally α- and/or ω-substituted with hydrocarbon group(s). In certain embodiments, the p-type semiconductor material can include a hole-transporting compound represented by formula (P-1), (P-2), (P-3), (P-4), (P-5) or (P-6): 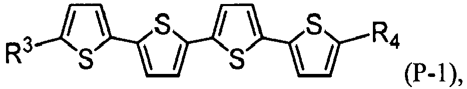 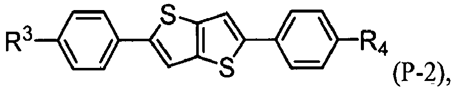 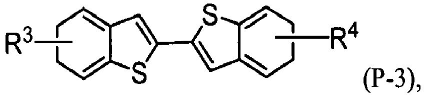 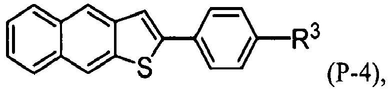 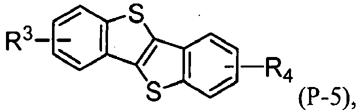 or 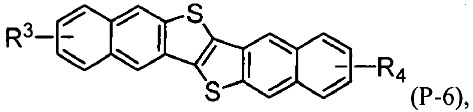 wherein R³ and R⁴ independently are H or identical or different C₁₋₂₀ alkyl groups. In particular embodiments, the p-type semiconductor material can include a hole-transporting compound selected from the group consisting of: 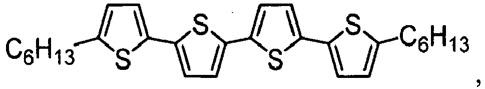 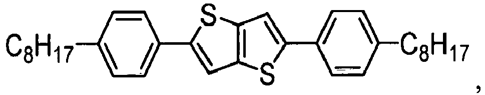 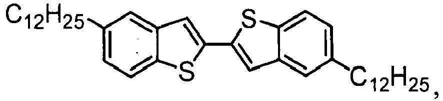 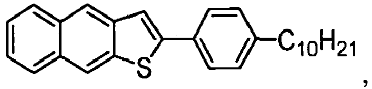 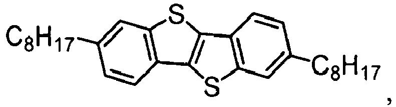 and

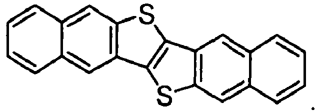

The p-type semiconductor material can be advantageously selected among condensed polycyclic aromatic compounds, preferably selected among benzothieno-benzothiophene compounds or dinaphtho-thienothiophene compounds.

In preferred embodiments, the p-type semiconductor material is selected among condensed polycyclic aromatic compounds having general formula (P-I) 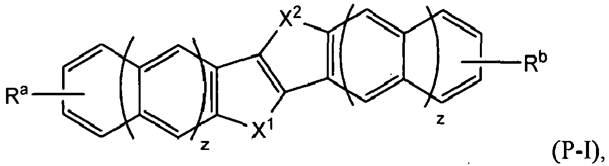 where
X¹ and X² are selected among S, O or Se and
R^{a} and R^{b} are independently selected from the group consisting of H, a C₁₋₁₈ alkyl group, and a C₆₋₁₄ aryl group, wherein each C₁₋₁₈ alkyl group and each C₆₋₁₄ aryl group optionally can be substituted with a phosphonate group; and z is 0 or 1.

In certain embodiments, at least one of R^{a} and R^{b} can be a C₁₋₁₈ alkyl or C₆₋₁₄ aryl group that is optionally substituted with a phosphonate group. For example, at least one of R^{a} and R^{b} can be a C₁₋₁₈ alkyl group optionally substituted with a phosphonate group (e.g., when z is 0).

Yet further enhanced light emission can be obtained if the p-type semiconductor material comprises a benzothieno-benzothiophene compound having general formula (P-II) 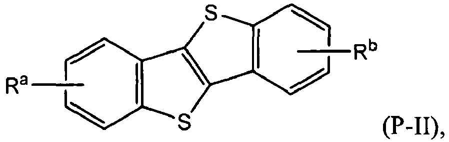 or a dinaphtho-thienothiophene compound having general formula (P-III) 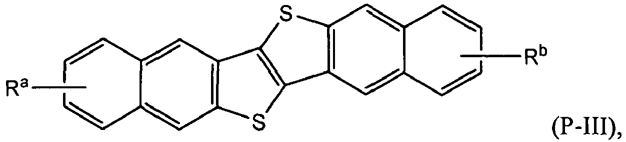 where R^{a} and R^{b} are as defined herein.

In preferred embodiments, the p-type semiconductor material is selected among 2,7-dioctyl[1]benzo-thieno[3,2-b][1]benzothiophene (C8-BTBT), 2,7-dipentyl[1]benzo thieno[3,2-b][1] benzothiophene (C5-BTBT), and dinaphtho[2,3-b:2',3'-f]thieno[3,2-b]thiophene (DNTT).

In certain embodiments, the n-type semiconductor material can be selected among bis(p-fluoroalkyl)phenyl-substituted oligomeric thiophene compounds, wherein the oligomeric thiophene compounds have 2, 3, 4, 5 or 6 thiophene moieties, optionally wherein two or more of the thiophene moieties are fused. Said n-type semiconductor material, as example, can be selected from the group consisting of a dithiophene, a quaterthiophene, and a thienothiophene.

In preferred embodiments, the n-type semiconductor material is selected among compounds having general formula (N-I): 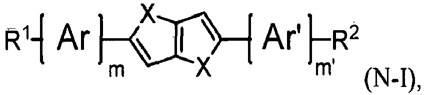 wherein:
X is selected from the group consisting of S, O, and Se;
Ar and Ar', at each occurrence, independently are identical or different monocyclic aryl or heteroaryl groups;
R¹ and R² independently are identical or different electron-withdrawing groups selected from the group consisting of -CN, R³, -C(O)R⁴, and -C(O)OR⁴; wherein R³ is an alkyl, alkenyl, or alkynyl group substituted with one or more F or CN groups, and R⁴ is an alkyl, alkenyl, or alkynyl group optionally substituted with one or more F or CN groups; and
m and m' independently are 1 or 2.

In particular embodiments, the n-type semiconductor material is selected between 2,5-bis(4-(perfluorooctyl)phenyl)thieno[3,2-b]thiophene (NF2-6), and 2,5-bis(4-(trifluoromethyl)phenyl)thieno[3,2-b]thiophene (NF2-6-CF3).

The dielectric layer can be an electrically insulating material selected from the group consisting of an inorganic oxide or nitride, a molecular dielectric, a polymeric dielectric, and combination thereof. In embodiments where the dielectric layer is a metal oxide or nitride, such dielectric material can be selected from the group consisting of SiO₂, Si₃N₄, Al₂O₃, ZrOₓ, Al-doped ZrOₓ, and HfOₓ. In embodiments where the dielectric layer is a molecular dielectric, such dielectric can be a self-assembled nanodielectric. In embodiments where the dielectric layer is a polymeric dielectric, such dielectric material can be selected from the group consisting of polyolefins, polyacrylates, polyimides, polyesters, and fluoropolymers. Hybrid organic/inorganic materials may also be used. In preferred embodiments, the dielectric layer comprises an organic dielectric, particularly, a polymeric dielectric.

OLETs according to the present invention can be fabricated using processes known in the art. For example, organic layers (e.g., the layer of emissive material, the layers of p-type and n-type semiconductor materials, and the organic dielectric layer of certain embodiments) can be formed by vapor-phase processes such as chemical vapor deposition or physical vapor deposition, as well as solution-phase processes such as printing (e.g., flexo printing, litho printing, gravure printing, ink-jetting, pad printing, and so forth), drop casting, slot coating, dip coating, doctor blading, roll coating, or spin-coating.

The hole/electron and gate electrodes can be formed using processing techniques known in the art. For example, any of the electrical contacts can be deposited through a mask, or can be deposited then etched or lifted off (photolithography). Suitable deposition techniques include electrodeposition, vaporization, sputtering, electroplating, coating, laser ablation and offset printing, from the same or different metals or metal alloys such as copper, aluminum, gold, silver, molybdenum, platinum, palladium, copper, titanium, chromium, and/or nickel, a transparent conducting oxide such as tin-doped indium oxide (ITO), or an electrically conductive polymer such as polyethylenethioxythiophene (PEDOT). Charge carrier injection can be facilitated by the use of a material for the injection electrode (hole electrode or electron electrode) that has a low barrier against injection of a charge carrier type into the hole transport sublayer and the electron transport sublayer, respectively. For example, the electron electrode can comprise one or more elements selected from the group consisting of Au, Ca, Mg, Al, In, and a perovskite manganites (RE₁₋ₓAₓMnO₃, RE = rare earth element such as La, Nd, Pr etc., A = alkaline metal). The hole electrode can comprise at least one material selected from the group consisting of Au, indium tin oxide, Cr, Cu, Fe, Ag, poly(3,4-ethylenedioxthiophene) combined with poly(styrenesulfonate) (PEDOT:PSS), and a perovskite manganite (Re₁₋ₓAₓMnO₃). In certain embodiments, the hole electrode and the electron electrode can be made of conductors with different work functions to favor both hole and electron injection.

If present, the hole and electron injection sublayers can be prepared by self-assembly of thiolates, phosphonates, or aliphatic or aromatic carboxylates; by thermal evaporation of various charge transfer complexes and other heteroaromatic or organometallic complexes; or by thermal evaporation or sputtering of various metal oxides, fluorides, or carbonates. The hole injection sublayer and the electron injection sublayer can be made of materials that provide a staircase of electronic levels between the energy level of the hole electrode and the electron electrode, and the energy level required for injection into the hole transport sublayer and the electron transport sublayer, respectively. *See e.g.,* Li et al., "Low operating-voltage and high power-efficiency OLED employing MoO3-doped CuPc as hole injection layer," Displays, 33(1): 17-20 (2012); Wen et al., "Self-assembled of conducting polymeric nanoparticles and its application for OLED hole injection layer," Energy Procedia, 12: 609-614 (2011); Zhang et al., "Role of Fe3O4 as a p-dopant in improving the hole injection and transport of organic light-emitting devices," IEEE Journal of Quantum Electronics, 47(5): 591-596 (2011); Choo et al., "Luminance and charge transport mechanisms for phosphorescent organic light-emitting devices fabricated utilizing a tris(2-phenylpyridine)iridium-doped N,N'-dicarbazolyl-3,5-benzene emitting layer," Thin Solid Films, 519(15): 5253-5256 (2011); Tao et al., "Odd-even modulation of electrode work function with self-assembled layer: Interplay of energy barrier and tunneling distance on charge injection in organic light-emitting diodes," Organic Electronics, 12(4): 602-608 (2011); Sung et al., "AC Field-Induced Polymer Electroluminescence with Single Wall Carbon Nanotubes," Nano Letters, 11(3): 966-972 (2011); Qiao et al., "Controlling charge balance and exciton recombination by bipolar host in single-layer organic light-emitting diodes," Journal of Applied Physics, 108(3): 034508/1-034508/8 (2011); Khizar-ul-Haq et al., "Blue organic light-emitting diodes with low driving voltage and enhanced power efficiency based on MoO3 as hole injection layer and optimized charge balance," Journal of Non-Crystalline Solids, 356(20-22): 1012-1015 (2010); Qi et al., "Analysis of metal-oxide-based charge generation layers used in stacked organic light-emitting diodes," Journal of Applied Physics, 107(1): 014514/1-014514/8 (201); Huang et al., "Materials and interface engineering in organic light-emitting diodes," Organic Electronics, 243-261 (2010); Helander et al., "Comparison of Alq3/alkali-metal fluoride/Al cathodes for organic electroluminescent devices," Journal of Applied Physics, 104(9): 094510/1-094510/6 (2008); Roy Choudhury et al., "LiF as an n-dopant in tris(8-hydroxyquinoline) aluminum thin films," Advanced Materials, 20(8): 1456-1461 (2008); Vacca et al., "Poly(3,4-ethylenedioxythiophene):poly(4-styrenesulfonate) ratio: Structural, physical and hole injection properties in organic light emitting diodes," Thin Solid Films, 516(12): 4232-4237 (2008); Yang et al., "Improved fabrication process for enhancing light emission in single-layer organic light-emitting devices doped with organic salt," Japanese Journal of Applied Physics, 47(2, Pt. 1): 1101-1103 (2008); Kim et al., "UV-ozone surface treatment of indium-tin-oxide in organic light emitting diodes," Journal of the Korean Physical Society, 50(6): 1858-1861 (2007); Prat et al., "Stable, highly efficient and temperature resistant organic light-emitting devices," Japanese Journal of Applied Physics, Part 1: Regular Papers, Brief Communications & Review Papers," 46(4A): 1727-1730 (2007); Luo et al., "Improving the stability of organic light-emitting devices by using a hole-injection-tunable-anode-buffer-layer," Journal of Applied Physics, 101(5): 054512/1-054512/4 (2007); Matsushima et al., "Charge-carrier injection characteristics at organic/organic heterojunction interfaces in organic light-emitting diodes," Chemical Physics Letters, 435(4-6): 327-330 (2007); Kim et al., "Controllable work function of Li-Al alloy nanolayers for organic light-emitting devices," Advanced Engineering Materials, 7(11): 1023-1027 (2005); Kato, "Designing Interfaces That Function to Facilitate Charge Injection in Organic Light-Emitting Diodes," Journal of the American Chemical Society, 127(33): 11538-11539 (2005); Veinot et al., "Toward the Ideal Organic Light-Emitting Diode. The Versatility and Utility of Interfacial Tailoring by Cross-Linked Siloxane Interlayers," Accounts of Chemical Research, 38(8): 632-643 (2005); Oyamada et al., "Extremely low-voltage driving of organic light-emitting diodes with a Cs-doped phenyldipyrenylphosphine oxide layer as an electron-injection layer," Applied Physics Letters, 86(3): 033503/1-033503/3 (2005); Hughes et al., "Electron-transporting materials for organic electroluminescent and electrophosphorescent devices," Journal of Materials Chemistry, 15(1): 94-107 (2005); D'Andrade et al., "Efficient organic electrophosphorescent white-light-emitting device with a triple doped emissive layer," Advanced Materials, 16(7): 624-628 (2004); Kanno et al., "Development of OLED with high stability and luminance efficiency by co-doping methods for full color displays," IEEE Journal of Selected Topics in Quantum Electronics, 10(1): 30-36 (2004); Han et al., "Transparent-cathode for top-emission organic light-emitting diodes," Applied Physics Letters, 82(16): 2715-2717 (2003); Tutis et al., "Internal electric field and charge distribution in multilayer organic light-emitting diodes," Journal of Applied Physics, 93(8): 4594-4602 (2003); Mathai et al., "Controlled injection of holes into AlQ3 based OLEDs by means of an oxidized transport layer," Materials Research Society Symposium Proceedings, 708(Organic Optoelectronic Materials, Processing and Devices): 101-106 (2002); Crone et al., "Charge injection and transport in single-layer organic light-emitting diodes," Applied Physics Letters, 73(21): 3162-3164 (1998); and Park et al., "Charge injection and photooxidation of single conjugated polymer molecules," Journal of the American Chemical Society, 126(13): 4116-7 (2004).

OLETs according to the present teachings can be fabricated on various substrates including plastic, flexible substrates that have a low temperature resistance. Examples of such flexible substrates include polyesters such as polyethylene terephthalate, polyethylene naphthalate, polycarbonate; polyolefins such as polypropylene, polyvinyl chloride, and polystyrene; polyphenylene sulfides such as polyphenylene sulfide; polyamides; aromatic polyamides; polyether ketones; polyimides; acrylic resins; polymethylmethacrylate, and blends and/or copolymers thereof. In some embodiments, the substrate can be a rigid transparent substrate such as glass, quartz and VYCOR®. Substrate-gate materials commonly used in thin-film transistors also can be used. Examples include doped silicon wafer, tin-doped indium oxide (ITO) on glass, tin-doped indium oxide on polyimide or mylar film, aluminum or other metals alone or coated on a polymer such as polyethylene terephthalate, a doped polythiophene, and the like.

The thicknesses of the various layers may be adapted in order to optimize performances and scaling down of the electroluminescent transistor of this disclosure. In this regards it is preferable to have the thickness of the layer of p-type semiconductor material comprised between 5 and 50 nm, preferably between 15 and 45 nm, the thickness of the layer of n-type semiconductor material may be comprised between 30 nm and 60 nm and the thickness of the layer of emissive material may be comprised between 30 nm and 60 nm.

A plurality of OLETs can be arranged in a matrix to provide a display device. The display device can include optional driving and switching elements, compensating transistor elements, capacitors, and/or light-emitting diodes. Particularly, such optional driving and switching elements and compensating transistor elements can be organic field-effect transistors.

The following examples are provided to illustrate further and to facilitate understanding of the present disclosure and are not in any way intended to limit the invention.

Acronyms are used in the examples to represent certain chemical compounds. The table below provides the IUPAC names and the acronyms of such compounds:

| | |
|---|---|
| **C8-BTBT** | 2,7-dioctyl[1]benzo-thieno[3,2-b][1]benzothiophene |
| **C5-BTBT** | 2,7-dipentyl[1]benzo-thieno[3,2-b][1]benzothiophene |
| **DNTT** | dinaphtho[2,3-b:2',3'-f]thieno[3,2-b]thiophene |
| **DH4T** | 5,5'-bis(3-hexyl-2-thienyl)-2,2'-bithiophene |
| **N-F2-6** | 2,5-bis(4-(perfluorooctyl)phenyl)thieno[3,2-b]thiophene |
| **N-F2-6-CF3** | 2,5-bis(4-(trifluoromethyl)phenyl)thieno[3,2-b]thiophene |
| **N-F4-1** | 2,6-bis(4-heptadecafluorooctylphenyl)-dithieno[3,2-b:2',3'-d] thiophene |
| **DFH4T** | 5,5'-bis((5-perfluorohexyl)thiophen-2-yl)-2,2'-bithiophene |
| **TCTA** | 4,4',4"-tris(carbazole-9-yl)triphenylamine |
| **NP4-CBP** | 4,4'-bis(3,6-dineopentyl-9H-carbazole-9-yl)-1,'-biphenyl |
| **Ir(piq)₃** | tris(1-phenylisoquinoline)iridium(III) |
| **Ir(ppy)₃** | tris(2-phenylpyridine)iridium(III) |
| **FIrpic** | bis(4,6-difluorophenyl-pyridine)(picolinate)iridium(III) |
| **PtOEP** | 2,3,7,8,12,13,17,18-octaethylporphyrin-22,24-diide; platinum(2+) |
| **Alq₃** | tris(8-hydroxyquinolinato)aluminium |
| **DCM** | 4-(dicyanomethylene)-2-methyl-6-(4-dimethylaminostyryl)-4H-pyran |

### Example 1

Making reference to figure 1, an organic ambipolar light emitting field effect transistor of this disclosure with simultaneous maximum light emission brightness and efficiency was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of C8-BTBT sublimated at a rate of 0.1 Å/s, while the substrate was maintained at room temperature;
- an emissive layer 5 in contact with the hole transport layer 4, in this case a 60 nm-thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F2-6 sublimated at a rate of 0.1Å/s, while the substrate was maintained at room temperature.

The metal source and drain electrodes 7 and 7', made of silver (Ag), were deposited in vacuum (10⁻⁶ mbar) and each had a thickness of 70 nm.

The device channel length (CL) and channel width (CW) were 70 µm and 12mm, respectively.

The so realized transistor showed the following characteristic parameters:
p-type threshold voltage = -40.1 V;
p-type-mobility = 5.2·10⁻¹ cm²/Vs;
n-type threshold voltage = 38.4 V;
n-type mobility= 3.6·10⁻³ cm²/Vs.

Current-voltage graphs of the organic electroluminescent transistor are shown in figures 2 and 3. The graph of figure 2 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 3 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 4 shows graphs of the external quantum efficiency (EQE, left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V).

As shown in figure 4, the tested organic electroluminescent transistor which has an emissive layer comprising a blend material that is composed of a carbazole derivative as the host matrix compound and an iridium complex as a guest emitter (in this case, TCTA:Ir(piq)₃) unexpectedly achieved maximum brightness (EL ∼ 45 µW) and efficiency (EQE > 2.25%) simultaneously.

### Example 2

Making reference to figure 1, an organic ambipolar light emitting field effect transistor of this disclosure with simultaneous maximum light emission brightness and efficiency was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of C5-BTBT sublimated at a rate of 0.1 Å/s, while the substrate was maintained at room temperature;
- an emissive layer 5 in contact with the hole transport layer 4, in this case a 60nm thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F2-6 sublimated at a rate of 0.1Å/s, while the substrate was maintained at room temperature.
The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -54.5 V;
p-type-mobility = 1.2·10⁻¹ cm²/Vs;
n-type threshold voltage = 25.9 V;
n-type mobility= 4.2·10⁻¹ cm²/Vs.

Current-voltage graphs of the organic electroluminescent transistor are shown in figures 5 and 6. The graph of figure 5 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 6 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 7 shows graphs of the external quantum efficiency (EQE, left scale - black curve) and of the electro-luminescence optical output power EL (right scale-gray curves) as a function of the gate-source voltage V_{GS} whilst the drain contact was maintained at a constant bias voltage of -100V and the source contact was grounded (V_{DS} = -100V).

As shown in figure 7, the tested organic electroluminescent transistor which has an emissive layer comprising a blend material that is composed of a carbazole derivative as the host matrix compound and an iridium complex as a guest emitter (in this case, TCTA:Ir(piq)₃) unexpectedly achieved maximum brightness (EL > 50 µW) and efficiency (EQE > 2.5%) simultaneously.

### Example 3

Making reference to figure 1, an organic ambipolar light emitting field effect transistor of this disclosure with simultaneous maximum light emission brightness and efficiency was realized from a substrate that comprises a first layer 1 of glass on which there was a transparent electrode 2 made of ITO (Indium Tin Oxide), on which there was a 450nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of DNTT sublimated at a rate of 0.1 Å/s, while the substrate was maintained at room temperature;
- an emissive layer 5 in contact with the hole transport layer 4, in this case a 60nm thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F2-6 sublimated at a rate of 0.1Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -40 V;
p-type-mobility = 5·10⁻⁵ cm²/Vs;
n-type threshold voltage = 34 V;
n-type mobility= 0.5 cm²/Vs.

Current-voltage graphs of the organic electroluminescent transistor are shown in figures 8 and 9. The graph of figure 8 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 9 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 10 shows graphs of the external quantum efficiency (EQE, left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V).

As shown in figure 10, the tested organic electroluminescent transistor which has an emissive layer comprising a blend material that is composed of a carbazole derivative as the host matrix compound and an iridium complex as a guest emitter (in this case, TCTA:Ir(piq)₃) unexpectedly achieved maximum brightness (EL ∼ 20 µW) and efficiency (EQE ∼ 2.5%) simultaneously.

### Example 4

Making reference to figure 1, an organic ambipolar light emitting field effect transistor of this disclosure with simultaneous maximum light emission brightness and efficiency was realized from a substrate that comprises a first layer 1 of glass on which there was a transparent electrode 2 made of ITO (Indium Tin Oxide), on which there was a 450nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 45 nm film made of DH4T sublimated at a rate of 0.1 Å/s, while the substrate was maintained at room temperature;
- an emissive layer 5 in contact with the hole transport layer 4, in this case a 60nm thick recombination layer composed of a host-guest organic structure (with guest dye concentration of 20%). TCTA was used as the host matrix and it was sublimated at a rate of 1 Å/s, while the substrate was maintained at room temperature. Ir(piq)₃ was used as the guest dye and it was sublimated at a rate of 0.25 Å/s, while the substrate was maintained at room temperature;
- an electron transport layer 6 in contact with the emissive layer 5, in this case a 45nm film of N-F4-1 sublimated at a rate of 0.1Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -49 V;
p-type-mobility = 1.3·10⁻¹ cm²/Vs;
n-type threshold voltage = null;
n-type mobility= null.

Current-voltage graphs of the organic electroluminescent transistor are shown in figures 11 and 12. The graph of figure 11 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 12 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 13 shows graphs of the external quantum efficiency (EQE, left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V).

As shown in figure 13, the tested organic electroluminescent transistor which has an emissive layer comprising a blend material that is composed of a carbazole derivative as the host matrix compound and an iridium complex as a guest emitter (in this case, TCTA:Ir(piq)₃) unexpectedly achieved maximum brightness (EL ∼ 2 µW) and efficiency (EQE ∼ 0.4%) simultaneously.

In contrast to the data obtained in Examples 1-4, organic electroluminescent transistors having an emissive layer comprising alternative blend materials were found to have significantly lower light emission brightness and/or efficiency. These comparative devices are described in Examples 5 and 6.

### Example 5 (Comparative)

A first comparative OLET having the same p-type and n-type semiconductor materials as the OLET in Example 4 was fabricated but with an alternative blend material (Alq₃:PtOEP) as the emissive layer.

Specifically, making reference to figure 1, the first comparative organic ambipolar light emitting field effect transistor was realized from a substrate that comprised a first layer 1 of glass on which there was a transparent electrode 2 made of ITO (Indium Tin Oxide), on which there was a 450nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- a hole transport layer 4 of p-type semiconductor material deposited over the layer of PMMA, in this case a layer of 15 nm film made of DH4T sublimated at a rate of 0.1 Å/s, while the substrate was maintained at room temperature;
- an emissive layer 5 in contact with the hole transport layer 4, in this case a 60nm thick recombination layer composed of a host-guest organic structure (with guest dye concentration of 20%). Alq₃ was used as the host matrix and it was sublimated at a rate of 1 Å/s, while the substrate was maintained at room temperature. PtOEP was used as the guest dye and it was sublimated at rate of 0.25 Å/s, while the substrate was maintained at room temperature;
- an electron transport layer 6 in contact with the emissive layer 5, in this case a 45nm film of N-F4-1 sublimated at a rate of 0.1Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) are 70µm and 12mm, respectively.

The so realized transistor showed the following characteristic parameters:
p-type threshold voltage = -55.2 V;
p-type-mobility = 3.8·10⁻² cm²/Vs;
n-type threshold voltage = null;
n-type mobility= null.

Current-voltage graphs of the organic electroluminescent transistor are shown in figures 14 and 15. The graph of figure 14 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 15 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of -100V and the source contact was grounded (V_{DS} = -100V).

Figure 16 shows graphs of the external quantum efficiency (EQE, left scale - black curve) and of the electro-luminescence optical output power EL (right scale - gray curves) as a function of the gate-source voltage V_{GS} whilst the drain contact was maintained at a constant bias voltage of -100V and the source contact was grounded (V_{DS} = -100V).

Referring to figure 16, the comparative device tested in this example showed much lower brightness (EL < 0.30 µW) compared to the device of Example 4 (EL ∼ 2 µW). Further, the maximum brightness was obtained under conditions when the efficiency was not optimized, and vice versa.

### Example 6 (Comparative)

The comparative device tested in this example incorporated the p-type semiconductor material (DH4T), the n-type semiconductor material (DFH4T), and the emissive material (Alq₃:DCM) used in the organic light-emitting transistor reported in the article "Organic light-emitting transistors with an efficiency that outperforms the equivalent light-emitting diodes" published in 2010 by Nature Materials, Volume 9, pages 496-503.

Making reference to figure 1, a comparative organic ambipolar light emitting field effect transistor was realized from a substrate that comprised a first layer 1 of glass on which there was a transparent electrode 2 made of ITO (Indium Tin Oxide), on which there was a 450 nm-thick dielectric layer 3 of poly(methyl methacrylate) (PMMA) fabricated by spin-coating and cured in vacuum environment at 90°C. An organic emissive ambipolar channel was sublimated in vacuum (10⁻⁷ mbar) and comprised:
- an electron transport layer 4 of n-type semiconductor material deposited over the layer of PMMA, in this case a layer of 15 nm film made of DFH4T sublimated at a rate of 0.1 Å/s, while the substrate was maintained at room temperature;
- an emissive layer 5 in contact with the hole transport layer 4, in this case a 60 nm-thick recombination layer composed of a host-guest organic structure (with guest dye concentration of 20%). Alq₃ was used as the host matrix and it was sublimated at a rate of 1 Å/s, while the substrate was maintained at room temperature. DCM was used as the guest dye and it was sublimated at rate of 0.25 Å/s, while the substrate was maintained at room temperature;
- a hole transport layer 6 in contact with the emissive layer 5, in this case a 45nm film of DH4T sublimated at a rate of 0.1 Å/s, while the substrate was maintained at room temperature.

The metal source and drain electrodes 7, made of silver (Ag), were deposited in vacuum (10⁻⁶ mbar) and each had a thickness of 70nm.

The device channel length (CL) and channel width (CW) were 70µm and 12mm, respectively.

The so realized transistor showed the following characteristic parameters:
p-type threshold voltage = -60 V;
p-type-mobility = 5.3·10⁻¹ cm²/Vs;
n-type threshold voltage = 23.7 V;
n-type mobility= 3.6·10⁻³ cm²/Vs.

Current-voltage graphs of the organic electroluminescent transistor are shown in figures 17 and 18. The graph of figure 17 illustrates variations of the drain-source current (I_{DS}) (left scale - black curves) and the electro-luminescence optical output power (EL) (right scale - gray curves) as a function of the drain-source voltage (V_{DS}) at different values of the gate-source voltage (V_{GS}), whilst the source contact was grounded. The graph of figure 18 illustrates variations of the drain-source current (I_{DS}) (left scale - black curve) and of the electro-luminescence optical output power (EL) (right scale - gray curves) as a function of the gate-source voltage (V_{GS}) whilst the drain contact was maintained at a constant bias voltage of 90V and the source contact was grounded (V_{DS} = 90V).

Figure 19 shows graphs of the external quantum efficiency (EQE, left scale - black curve) and of the electro-luminescence optical output power EL (right scale - gray curves) as a function of the gate-source voltage V_{GS} whilst the drain contact was maintained at a constant bias voltage of 90V and the source contact was grounded (V_{DS} = 90V).

As shown in figure 19, the comparative device tested in this example, which incorporated a combination of materials previously reported in the art, showed much lower brightness (EL < 0.25 µW) and efficiency (EQE < 0.8%) compared to the devices of Examples 1-3. Further, the maximum brightness was obtained under conditions when the efficiency was very low, and vice versa.

Examples 1-4 demonstrate that organic electroluminescent transistors which have an emissive layer composed of a blend material including a carbazole derivate as the host matrix compound and an iridium complex as the guest emitter in general show a higher source-drain current and a higher optical output power (EL) compared to comparative devices described in examples 5 and 6, which incorporates other host-guest matrices as the emissive layer.

Moreover, the organic electroluminescent transistors of examples 1, 2 and 3 show significantly higher emission quantum efficiencies (EQE) values (see Figs. 4, 7 and 10, left scale) compared to the comparative devices described in examples 5 and 6. The EQE values of the transistors of examples 1, 2 and 3 oscillate around a constant value during gate bias sweep (oscillations within 10-20% of maximum EQE value) providing simultaneous achievement of maximum brightness and efficiency. In example 5 (Fig. 16, left scale), a substantial deterioration of EQE was observed at increased gate biases (a decrease of about 40% with respect to its maximum value occurred). Analogous deterioration was observed with example 6.

That the devices demonstrated in Examples 1-4 showed such high optical output power and efficiency was made more unexpected by the fact that a polymeric dielectric (PMMA) was used as the dielectric layer, compared to conventional OLETs and OFETs which typically show optimal device performance when an inorganic dielectric such as SiOₓ is used as the dielectric layer.

## Claims

1. An organic electroluminescent transistor, comprising at least one dielectric layer; at least one control electrode and an assembly comprising an emissive ambipolar channel, at least one source electrode and at least one drain electrode, wherein:
said dielectric layer is arranged between said control electrode and said assembly;
said ambipolar channel comprises at least one layer of an n-type semiconductor material, at least one layer of a p-type semiconductor material and at least one layer of an emissive material arranged between said layers of p-type and n-type semiconductor materials;
**characterized in that** said emissive material is a blend comprising a arylamine matrix compound selected among compounds represented by either formula (H-1) or (H-2) 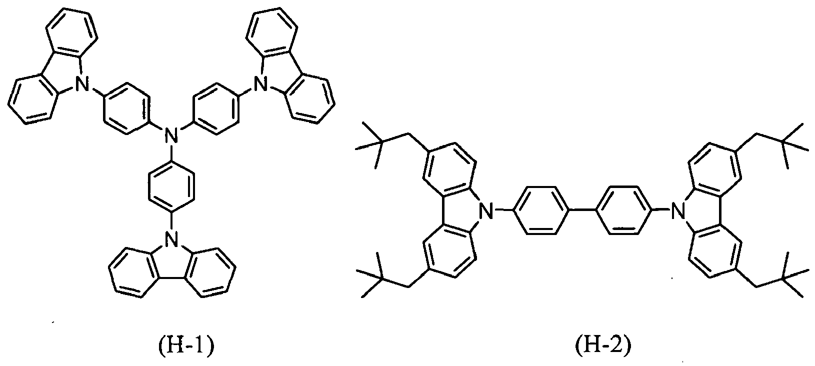
and an emitter being selected among compounds represented by formula (G-1), (G-2), or (G-3)

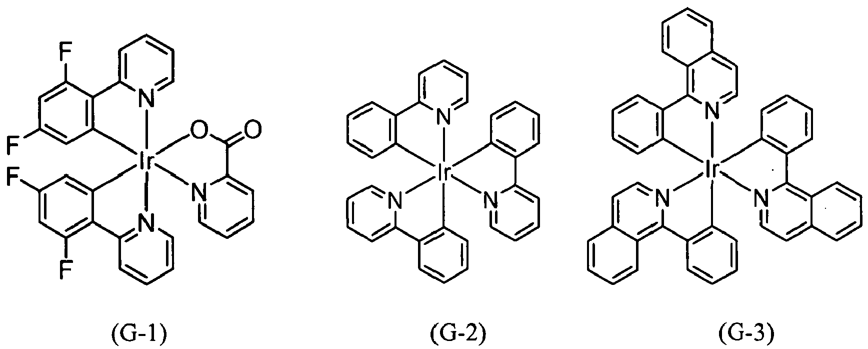

2. An organic electroluminescent transistor according to claim 1, **characterized in that** said layer of emissive material has a thickness between 30 nm and 60 nm.

3. An organic electroluminescent transistor according to claim 1, **characterized in that** said arylamine matrix compound is 4,4',4"-tris(carbazole-9-yl)triphenylamine and said emitter is tris(1-phenylisoquinoline)iridium(III).

4. An organic electroluminescent transistor according to claim 1, **characterized in that** said arylamine matrix compound is 4,4'-bis(3,6-dineopentyl-9H-carbazole-9-yl)-1,'-biphenyl and said emitter is tris(1-phenylisoquinoline)iridium(III).

5. An organic electroluminescent transistor according to claim 1, **characterized in that** said arylamine matrix compound is 4,4'-bis(3,6-dineopentyl-9H-carbazole-9-yl)-1,'-biphenyl and said emitter is tris(2-phenylpyridine)iridium(III).

6. An organic electroluminescent transistor according to claim 1, **characterized in that** said arylamine matrix compound is 4,4'-bis(3,6-dineopentyl-9H-carbazole-9-yl)-1,'-biphenyl and said emitter is bis(4,6-difluorophenyl-pyridine)(picolinate)iridium(III)

7. An organic electroluminescent transistor according to claim 1, **characterized in that** said layer of emissive material contains a concentration of a transition metal complex that is comprised between 10 and 22% of the total weight of said emissive layer.

8. An organic electroluminescent transistor according to claim 1 wherein the p-type semiconductor material is selected among condensed polycyclic aromatic compounds, preferably selected among benzothieno-benzothiophene compounds or dinaphtho-thienothiophene compounds.

9. An organic electroluminescent transistor according to claim 1 wherein the thickness of said layer of p-type semiconductor material is comprised between 5 and 50 nm.

10. An organic electroluminescent transistor according to claim 9 wherein the thickness of said layer of p-type semiconductor material is comprised between 15 and 45 nm.

11. An organic electroluminescent transistor according to claim 1 wherein said n-type semiconductor material comprises a bis(p-fluoroalkyl)phenyl-substituted oligomeric thiophene compound, wherein the oligomeric thiophene compound has 2, 3, 4, 5 or 6 thiophene moieties, optionally wherein two or more of the thiophene moieties are fused.

12. An organic electroluminescent transistor according to claim 11 wherein the bis(p-fluoroalkyl)phenyl-substituted oligomeric thiophene compound is selected from the group consisting of a dithiophene, a quaterthiophene, and a thienothiophene.

13. An organic electroluminescent transistor according to claim 1, **characterized in that** the thickness of said layer of n-type semiconductor material is comprised between 30 nm and 60 nm.

14. An organic electroluminescent transistor according to claim 1 wherein said source electrode is in contact with said layer of p-type semiconductor material and said drain electrode is in contact with said layer of n-type semiconductor material.

15. An organic electroluminescent transistor according to claim 1 wherein said source electrode and said drain electrode are composed of at least one different material.

16. An organic electroluminescent transistor according to claim 1 wherein an injection sublayer is interposed between said source electrode and the p-type or n-type semiconductor material and/or an injection sublayer is interposed between said drain electrode and the p-type or n-type semiconductor material.

17. An organic electroluminescent transistor according to claim 1, wherein each of the control electrode, drain electrode, and source electrode independently comprises a metal or a transparent conducting oxide selected from the group consisting of gold, silver, molybdenum, copper, titanium, chromium, tin-doped indium oxide and combination thereof.

18. An organic electroluminescent transistor according to claim 1, wherein the dielectric layer comprises an electrically insulating material selected from the group consisting of an inorganic oxide or nitride, a molecular dielectric, a polymeric dielectric, and combination thereof.

19. An organic electroluminescent transistor according to claim 1, wherein the inorganic oxide or nitride is selected from the group consisting of SiO₂, Si₃N₄, Al₂O₃, ZrOₓ, Al-doped ZrOₓ, and HfOx.

20. An organic electroluminescent transistor according to claim 1, further comprising a passivation layer covering a top surface of the emissive ambipolar channel.

21. An optoelectronic device for producing an image, the optoelectronic device comprising a plurality of identical or different organic electroluminescent transistors according to any one of previous claims, interconnected to each other and deposited on a substrate.
